Europäisches Patentamt

(19) European Patent Office

Office européen des brevets

(11) Veröffentlichungsnummer: **0 185 155**
**B1**

(12) # EUROPÄISCHE PATENTSCHRIFT

(45) Veröffentlichungstag der Patentschrift:
28.02.90

(21) Anmeldenummer: 85112489.1

(22) Anmeldetag: 03.10.85

(51) Int. Cl. ⁵: **G 03 F   7/16**

(54) Photopolymerisierbares Aufzeichnungsmaterial und Verfahren zu seiner Herstellung.

(30) Priorität: 12.10.84 DE 3437453

(43) Veröffentlichungstag der Anmeldung:
25.06.86 Patentblatt 86/26

(45) Bekanntmachung des Hinweises auf die Patenterteilung:
28.02.90 Patentblatt 90/09

㊗ Bennante Vertragsstaaten:
DE FR GB

(56) Entgegenhaltungen:
US-A-4 148 395

(73) Patentinhaber: HOECHST AKTIENGESELLSCHAFT
Postfach 80 03 20
D-6230 Frankfurt am Main 80 (DE)

(72) Erfinder: Hilger, Manfred
Langenbergring 75
D-5503 Konz (DE)
Erfinder: Klein, Norbert, Dipl.-Ing.
Erbsenacker 17
D-6200 Wiesbaden (DE)

**Beschreibung**

Photopolymerisierbares Aufzeichnungsmaterial und Verfahren zu seiner Herstellung

Die Erfindung betrifft ein photopolymerisierbares Aufzeichnungsmaterial in Form einer Vorratsrolle, insbesondere ein Trockenphotoresistmaterial aus einer Trägerfolie, einer photopolymerisierbaren Schicht und einer Deckfolie.

Materialien der genannten Gattung sind z. B. aus der US-A-3 469 982 bekannt und werden in großem Umfang zur Herstellung von gedruckten Schaltungen und für ähnliche Anwendungen eingesetzt.

Die thermoplastische Photoresistschicht dieser Materialien muß sich zur trockenen Übertragung auf ein anderes Trägermaterial, z. B. eine Kupferplatte, unter Druck und zumeist unter Erwärmen eignen. Das bedeutet, daß die Schicht zumindest thermoplastisch, vorteilhaft auch bei Normaltemperatur schon plastisch verformbar sein muß und eine gewisse Klebrigkeit haben soll. Materialien, die diese Verarbeitungseigenschaften in optimalem Maße aufweisen, bereiten bei der Lagerung und beim Transport in unbelichtetem Zustand gewisse Probleme. Diese Schichten neigen stets zu einem gewissen kalten Fluß, der sich dadurch bemerkbar macht, daß die Schicht beim Lagern in der Rolle an deren Stirnseiten zwischen den Folien herausquillt und die Wickellagen miteinander verklebt. Man hat dieses Problem dadurch zu lösen versucht, daß man die Schichtzusammensetzung, insbesondere die Natur des thermoplastischen Bindemittels so geändert hat, daß die Fließtemperatur der Schicht heraufgesetzt wird. Dieser Lösung, die z. B. in der DE-A-2 363 806 beschrieben ist, sind deshalb Grenzen gesetzt, weil mit dem Anstieg der Fließtemperatur der unbelichteten Schicht die Sprödigkeit der lichtvernetzten Schicht zunimmt, so daß sich das belichtete Material schlechter verarbeiten läßt.

Eine andere Lösung des Problems wird in der DE-C-2 345 120 beschrieben. Dabei werden die Ränder der Photoresistschicht gehärtet, so daß sie nicht mehr ausfließen kann. Ein Nachteil dieses Verfahrens ist es, daß bei der Verarbeitung des entsprechenden Materials an den Randstreifen Verluste an lichtempfindlicher Substanz entstehen, denn um mit Sicherheit alle anpolymerisierten Anteile der Schicht bei der späteren Kopie auszuschließen, muß ein gewisser Sicherheitsabstand gewählt werden. Auch kann durch die Härtung des Randstreifens eine Änderung des relativen Haftvermögens der Schicht an der Träger- und Deckfolie eintreten, so daß die Schicht in unerwünschter Weise an der Deckfolie stärker haften kann als an der Trägerfolie.

Aufgabe der Erfindung war es, ein photopolymerisierbares Aufzeichnungsmaterial vorzuschlagen, das bei der Lagerung im Wickel keinen störenden Randaustritt der photopolymerisierbaren Schicht zeigt, das bei der Verarbeitung keine Materialverluste erfordert und bei dem das Haftvermögen der Schicht an der Träger- und Deckfolie bis zur Trennung des Verbunds unverändert bleibt.

Die Erfindung geht aus von einem photopolymerisierbaren Aufzeichnungsmaterial aus einer flexiblen, transparenten, maßbeständigen temporären Trägerfolie, einer darauf aufgebrachten thermoplastischen übertragbaren photopolymerisierbaren Photoresistschicht und einer flexiblen Deckfolie auf der anderen Seite der Photoresistschicht, die an der Photoresistschicht schwächer haftet als die Trägerfolie, in Form einer Rolle.

Das erfindungsgemäße Aufzeichnungsmaterial ist dadurch gekennzeichnet, daß die Stirnseiten der Rolle mit aufgeklebten Abdeckscheiben abgedeckt sind.

Erfindungsgemäß wird ferner ein Verfahren zur Herstellung eines lagerfähigen photopolymerisierbaren Aufzeichnungsmaterials vorgeschlagen, bei dem man auf eine flexible, transparente, maßbeständige Trägerfolie eine thermoplastische übertragbare photopolymerisierbare Photoresistschicht aufbringt, die freiliegende Oberfläche der Photoresistschicht mit einer flexiblen Deckfolie kaschiert und das erhaltene Schichtgebilde zu einer Vorratsrolle aufwickelt.

Das erfindungsgemäße Verfahren ist dadurch gekennzeichnet, daß man die Stirnseiten der Vorratsrolle durch Aufkleben von Abdeckscheiben abdeckt.

Als Abdeckscheiben oder -manschetten werden normalerweise kreis- bzw. ringförmige Scheiben aus Papier, Kunststoffolien, Textilgeweben oder Faservliesen verwendet, die mit Klebstoff beschichtet sind. Der Klebstoff kann entweder bei Normaltemperatur aktiv oder ein Schmelzkleber sein. Normalerweise werden die Abdeckscheiben aus flexiblem, vorzugsweise reißfestem Material, z. B. Kunststoffolie oder Textilgewebe hergestellt. In diesem Falle lassen sich die Scheiben, wenn gewünscht, leicht wieder entfernen. Es ist auch möglich, daß die Scheiben aus einem relativ starren Material, z. B. Pappe oder starrem Kunststoff, bestehen, wenn eine bessere Stabilisierung des Wickels erwünscht ist. Die Scheiben sind zweckmäßig kreisförmig und dem Durchmesser der Rolle angepaßt. Vorzugsweise wird ein konzentrischer Innenkreis ausgespart, damit die Scheiben über den überstehenden Wickelkern geschoben werden können.

Die beiliegenden Zeichnungen veranschaulichen das erfindungsgemäße Aufzeichnungsmaterial.

Fig. 1    zeigt eine Trockenresistrolle, deren Stirnseiten mit abziehbaren Abdeckscheiben versehen sind,
Fig. 2    zeigt eine entsprechende Rolle, deren Stirnseiten mit starren Abdeckscheiben versehen sind.

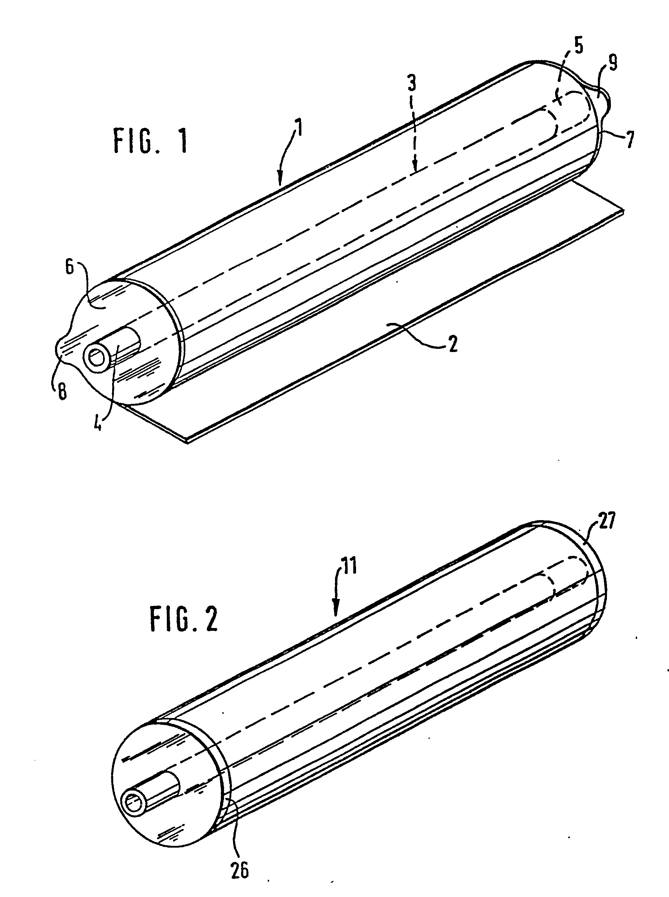

In Fig. 1 ist eine Trockenresistrolle 1 dargestellt, die aus Trockenresistfolie 2 besteht, die auf einen Wickelkern 3 gewickelt ist. Die Enden des Wickelkerns 3 stehen als Zapfen 4 und 5 über die Rollenbreite über. Auf die Stirnseiten der Rolle sind ringförmige Abdeckmanschetten 6 und 7 aufgeklebt, die Laschen 8 und 9 aufweisen, mittels derer sie bei Bedarf wieder abgezogen werden können. In Fig. 2 ist eine ähnliche Trockenresistrolle 11 dargestellt, deren Stirnseiten mit starren Klebmanschetten 26 und 27 abgedeckt sind.

Die Abdeckscheiben werden im Zuge der Herstellung des Trockenresistmaterials aufgebracht. Dabei wird eine Trägerfolie, die vorzugsweise aus Polyester besteht, mit einer Lösung der photopolymerisierbaren Mischung beschichtet und getrocknet. Die freiliegende Oberfläche der photopolymerisierbaren Schicht wird dann mit einer Deckfolie, die vorzugsweise aus einem Polyolefin besteht, durch Laminieren haftfest verbunden. Das erhaltene Laminat wird zu einer Großrolle aufgewickelt. Das Material wird dann zu verbrauchsgerechten Breiten und Längen geschnitten. Gewöhnlich werden Rollen von etwa 20 bis 80 cm Breite hergestellt, die so bemessen sind, daß sie auf handelsüblichen Verarbeitungsgeräten verarbeitet werden können. Der Rollendurchmesser hängt von dem Durchmesser des Wickelkerns und der Stärke des Laminats ab. Bei einer Länge der Resistfolie von 100 bis 300 m kann der Rollendurchmesser etwa 8 bis 25 cm betragen.

Bei der Fertigung der Rollen muß die Wickelspannung sehr sorgfältig kontrolliert werden. Die Spannung soll sowohl über die Breite der Rolle als auch auf der ganzen Länge der aufzuwickelnden Bahn stets gleich bleiben. Unterschiedliche Spannungen führen regelmäßig zum Ausquellen der Schichtsubstanz an den Stellen höherer Spannung und damit zu einem ungleichmäßigen Verschmieren der Stirnflächen der Rolle. Wenn die Rolle zu locker gewickelt ist, können die unterschiedlichen Spannungen auch zu einer gegenseitigen Verschiebung der Wickellagen ("Teleskopieren") führen. Wegen der unvermeidlichen Dickenschwankungen der Folien und der photopolymerisierbaren Schicht lassen sich diese unerwünschten Wirkungen nie ganz vermeiden.

Entsprechend dem Durchmesser der Rolle und des Wickelkerns wird dann z. B. aus einer geeigneten handelsüblichen Klebefolie ein passendes ringförmiges Stück ausgestanzt und unter Druck auf die Rollenstirnseite aufgebracht. Die Rolle ist dadurch gegen unerwünschtes Ausquellen von Schichtsubstanz geschützt. Zugleich wird die Gefahr vermieden, daß Bedienungspersonen, die bei der Handhabung der Rollen mit den Stirnseiten in Berührung kommen, Hautreizungen durch die photopolymerisierbaren Acryl- oder Methacrylsäureester erleiden. Eine weitere vorteilhafte Wirkung der aufgeklebten Abdeckscheiben besteht darin, daß sie ein Verrutschen der Lagen des Wickels, das sogenannte Teleskopieren, verhindern oder weitgehend unterdrücken. Außerdem wird die Einwirkung von Licht und Luftfeuchtigkeit bei der Lagerung auf die Resistschicht verhindert.

Bei der Anwendung werden die Abdeckscheiben von der Rolle entfernt, bevor diese in das Laminiergerät eingesetzt wird. Soweit bei der Lagerung Schichtanteile in geringem Maße aus der Stirnseite der Rolle ausgetreten sind, werden diese von der Klebschicht mitgerissen, so daß eine saubere Rollenstirnseite zurückbleibt. Es ist auch möglich, starre Abdeckscheiben zu verwenden. Durch sie kann das oben erwähnte Teleskopieren der Rolle noch weiter unterdrückt werden. Auch kann statt eines bei Normaltemperatur wirksamen Klebers ein Schmelzkleber bzw. eine Heißsiegelschicht verwendet werden. In diesem Falle werden die Abdeckscheiben unter entsprechendem Erwärmen aufgepreßt. Gemäß einer besonderen Ausführungsform kann anstelle eines Schmelzklebers auch eine thermoplastische Photoresistschicht verwendet werden, wie sie für das Trockenphotoresistmaterial eingesetzt wird.

Als Basismaterial für die Abdeckscheiben bzw. -manschetten können Folien aus Kunststoffen, wie Polyester, Polyethylen, Polypropylen, Polyvinylchlorid oder dgl. eingesetzt werden. Durch Verstrecken kann die Maßbeständigkeit der Folien erhöht werden. Ferner ist Papier oder Pappe, Faservlies oder Textilgewebe geeignet.

Als Kleberschicht werden meist übliche druckempfindliche Klebstoffe auf Acrylatbasis eingesetzt. Als Schmelzkleber können in bekannter Weise Polyvinylacetat, Vinylacetatmischpolymerisate, Acrylesterpolymerisate, Polybutene, Polyethylene, Mischpolyester von Isophthalsäure und Terephthalsäure und Naturharze, wie Mastix oder Kopal verwendet werden. Wenn als Schmelzkleber eine thermoplastische Photoresistschicht verwendet wird, hat diese zweckmäßig die gleiche Zusammensetzung wie die Photoresistschicht des Trockenresistmaterials.

Die Trockenphotoresistmaterialien, die erfindungsgemäß mit Abdeckscheiben versehen werden, sind bekannt und z. B. in den DE-A-2 064 079, 2 363 806, 2 123 702, 2 822 190 und 3 134 123 beschrieben. Sie bestehen im allgemeinen, wie bereits erwähnt, aus einer maßbeständigen Trägerfolie, einer photopolymerisierbaren Schicht und einer Deckfolie. Die Trägerfolie hat vorzugsweise eine Stärke im Bereich von 15 bis 30 µm, die Deckfolie eine Stärke von 5 bis 25 µm. Die photopolymerisierbare Schicht enthält als Hauptbestandteile ein thermoplastisches polymeres Bindemittel, polymerisierbare Verbindungen, die vorzugsweise Acryl- oder Methacrylsäureester mehrwertiger aliphatischer Hydroxyverbindungen sind, und einen Photopolymerisationsinitiator. Weitere übliche Bestandteile können Polymerisationsinhibitoren, Farbstoffe, Pigmente, Weichmacher und Vernetzungsmittel sein. Die Schichtdicke liegt im allgemeinen zwischen 10 und 100, vorzugsweise zwischen 15 und 70 µm.

Die folgenden Beispiele beschreiben bevorzugte Ausführungsformen der Erfindung. Gewichtsteile (Gt) und Volumteile (Vt) stehen im Verhältnis von g zu ccm, Prozentzahlen und Mengenverhältnisse sind in Gewichtseinheiten zu verstehen, wenn nichts anderes angegeben ist.

**Beispiel 1**

Auf eine 110 cm breite Bahn aus biaxial verstreckter und thermofixierter Polyethylenterephthalatfolie von 23 µm Stärke wurde eine 40 µm dicke photopolymerisierbare Schicht der folgenden Zusammensetzung aufgebracht:

6,5 Gt eines Terpolymerisats aus n-Hexylmethacrylat, Methacrylsäure und Styrol (60 : 30 : 10) mit einem mittleren Molgewicht von ca. 35000,

2,8 Gt eines polymerisierbaren Diurethans, das durch Umsetzung von 1 mol 2,2,4-Trimethylhexamethylendiisocyanat mit 2 mol Hydroxyethylmethacrylat erhalten wurde,

2,8 Gt    eines polymerisierbaren Polyurethans aus 11 mol 2,2,4-Trimethyl-hexamethylen-diisocyanat, 10 mol Triethylenglykol und 2 mol Hydroxyethylmethacrylat,

0,2 Gt    9-Phenyl-acridin,

0,1 Gt    3-Mercapto-propionsäure-2,4-dichlor-anilid,

0,035 Gt    eines blauen Azofarbstoffs, erhalten durch Kuppeln von 2,4-Dinitro-6-chlor-benzol-diazoniumsalz mit 2-Methoxy-5-acetylamino-N-cyanoethyl-N-hydroxyethylanilin und

2,8 Gt    4-Hydroxy-benzoesäure-(2-ethyl-hexyl)ester

Auf die Oberfläche der trockenen Schicht wurde dann im kontinuierlichen Betrieb eine ca. 12 µm dicke Polyethylenfolie durch Laminieren aufgebracht. Das erhaltene Laminat wurde auf einer Großrolle gespeichert. Mittels eines Rollenschneiders wurde die Trockenresistfolie zu Bahnen von 45 cm Breite zerschnitten und zu Rollen von 200 m Bahnlänge auf Wickelkerne von 7,5 cm Durchmesser aufgewickelt, die an jeder Seite der Rolle um ca. 1 cm überstanden.

Aus einer mit Kleber beschichteten Folie wurden zwei ringförmige über die Enden der Wickelkerne passende Manschetten ausgestanzt, um die Stirnseiten eines Folienwickels zu bedecken. Die Abdeckmanschetten hatten jeweils am äußeren Rand eine überstehende Lasche, die nicht mit Kleber beschichtet war, und wurden mit einer Handrolle fest an die Stirnseiten des Wickels angedrückt. Nach 1 Monat Lagerung bei 15 °C wurden die Manschetten mittels der überstehenden Laschen abgezogen und untersucht. Auf den Klebflächen wurden praktisch keine Schichtbestandteile, die anhand ihrer blauen Farbe leicht zu erkennen sind, gefunden.

Eine weitere in gleicher Weise an den Stirnseiten abgedeckte Rolle wurde 5 Tage in einem Wärmeschrank bei 45 °C gelagert. Auf den Klebflächen der abgezogenen Manschetten waren geringe Abscheidungen von Schichtbestandteilen erkennbar. Die Stirnkanten des Wickels selbst waren völlig frei von überstehenden oder verlaufenen Schichtteilen.

Eine weitere Rolle wurde ohne Abdeckmanschetten 5 Tage bei 45 °C gelagert. Die Untersuchung der Stirnkanten ergab stellenweise erhebliche Mengen ausgequollener Schichtsubstanz, die über die einzelnen Lagen des Wickels übergreifend verlaufen war und beim Abwickeln in der Laminiervorrichtung sowie beim Abtrennen der Deckfolie von der Photoresistschicht zu Störungen, z. B. zum Einreißen der Photoresistschicht oder zum Haften dieser Schicht an der Deckfolie, führte.

## Beispiel 2

Eine Polyesterfolie wurde, wie in Beispiel 1 beschrieben, mit einer 45 µm dicken Schicht der folgenden Zusammensetzung überzogen:

2,8 Gt    eines Terpolymerisats aus Methylmethacrylat n-Hexylmethacrylat und Methacrylsäure (75 : 375 : 90) mit der Säurezahl 209,

2,8 Gt    eines ungesättigten Diurethans, erhalten durch Umsetzen von 1 mol 2,2,4-Trimethyl-hexamethylendiisocyanat mit 2 mol Hydroxy-ethylmethacrylat,

0,2 Gt    9-phenyl-acridin,

0,25 Gt    Triethylenglykoldiacetat und

0,03 Gt    Tris-[4-(3-methyl-phenylamino)phenyl]methyl-acetat

Die Schicht wurde mit einer Polyethylenfolie laminiert und das Laminat zu Rollen von 45 cm Breite wie in Beispiel 1 verarbeitet. Aus 1 mm starker Pappe wurden passende Manschetten ausgestanzt, mit handelsüblichem Kontaktkleber bestrichen und auf die Stirnseiten unter Druck aufgeklebt. Auch bei unsachgemäßer Lagerung unter ungleichmäßiger Auflage der Stirnseiten des Wickels behielt dieser seine Form im wesentlichen bei. Er wurde zum Gebrauch ohne Abtrennung der Manschetten in eine Laminiervorrichtung eingelegt. Die Trockenresistfolie ließ sich ohne Schwierigkeit von dem Wickel abziehen und wie gewohnt verarbeiten. Durch die an der Rolle verbliebenen Abdeckmanschetten wurde das Ausquellen der Schicht auch bei längeren Unterbrechungen der Verarbeitung verhindert.

Die Abdeckmanschetten können auch aus passenden Kunststoffscheiben bestehen, die mit einem doppelseitig beschichteten Klebeband bedeckt sind. Der Durchmesser der Abdeckmanschetten kann auch größer als der der Resistrolle sein.

Wenn eine in gleicher Weise hergestellte Trockenresistrolle ohne Abdeckmanschetten wenige Wochen, wie oben erwähnt, unter ungleichmäßiger Auflage gelagert wurde, hatten sich die Wickellagen teleskopartig verschoben, so daß die Rolle nicht mehr in das dafür vorgesehene Verarbeitungsgerät eingelegt werden konnte.

4

## Patentansprüche

1. Photopolymerisierbares Aufzeichnungsmaterial aus einer flexiblen, transparenten, maßbeständigen temporären Trägerfolie, einer darauf aufgebrachten thermoplastischen übertragbaren photopolymerisierbaren Photoresistschicht und einer flexiblen Deckfolie auf der anderen Seite der Photoresistschicht, die an der Photoresistschicht schwächer haftet als die Trägerfolie, in Form einer Rolle, dadurch gekennzeichnet, daß die Stirnseiten der Rolle mit aufgeklebten Abdeckscheiben abgedeckt sind.

2. Aufzeichnungsmaterial nach Anspruch 1, dadurch gekennzeichnet, daß die Abdeckscheiben aus mit Kleber beschichteten flexiblen Papier, Textil- oder Folienblättern bestehen.

3. Aufzeichnungsmaterial nach Anspruch 2, dadurch gekennzeichnet, daß der Kleber ein Heißkleber ist.

4. Aufzeichnungsmaterial nach Anspruch 2, dadurch gekennzeichnet, daß der Kleber ein druckempfindlicher Klebstoff ist.

5. Aufzeichnungsmaterial nach Anspruch 1, dadurch gekennzeichnet, daß die Abdeckscheiben starr sind.

6. Verfahren zur Herstellung eines lagerfähigen photopolymerisierbaren Aufzeichnungsmaterials, bei dem man auf eine flexible, transparente, maßbeständige Trägerfolie eine thermoplastische übertragbare photopolymerisierbare Photoresistschicht aufbringt, die freiliegende Oberfläche der Photoresistschicht mit einer flexiblen Deckfolie kaschiert und das erhaltene Schichtgebilde zu einer Vorratsrolle aufwickelt, dadurch gekennzeichnet, daß man die Stirnseiten der Vorratsrolle durch Aufkleben von Abdeckscheiben abdeckt.

7. Verfahren nach Anspruch 6, dadurch gekennzeichnet, daß man mit Heißkleber beschichtete Abdeckscheiben verwendet und sie unter Druck und Erwärmen aufklebt.

8. Verfahren nach Anspruch 6, dadurch gekennzeichnet, daß die Abdeckscheiben flexibel sind und vor Gebrauch der Rolle wieder abgezogen werden.

## Revendications

1. Matériau d'enregistrement photopolymérisable se composant d'une pellicule support temporaire, flexible, transparente et présentant une stabilité dimensionnelle, d'une couche de photorésist photopolymérisable, transférable, thermoplastique, disposée sur la pellicule support, et d'une pellicule de recouvrement flexible disposée sur l'autre face de la couche de photorésist et qui adhère moins bien à la couche de photorésist que la pellicule support, le matériau étant voulé en un rouleau, caractérisé en ce que les faces d'extrémité du rouleau sont recouvertes par des disques de recouvrement collés.

2. Matériau d'enregistrement selon la revendication 1, caractérisé en ce que les disques de recouvrement se composent de papier, de feuilles textiles ou de feuilles pelliculaires flexibles, enduites de colle.

3. Matériau d'enregistrement selon la revendication 2, caractérisé en ce que la colle est un thermoadhésif.

4. Matériau d'enregistrement selon la revendication 2, caractérisé en ce que la colle est un adhésif sensible à l'effet de pression.

5. Matériau d'enregistrement selon la revendication 1, caractérisé en ce que les disques de recouvrement sont rigides.

6. Procédé de production d'un matériau d'enregistrement photopolymérisable pouvant être stocké, selon lequel on dispose sur une pellicule support flexible, transparente et présentant une stabilité dimensionnelle une couche de photorésist photopolymérisable, transférable et thermoplastique, on contrecolle une pellicule de recouvrement flexible sur la face libre de la couche de photorésist et on roule le produit stratifié obtenu en un rouleau de réserve, caractérisé en ce qu'on recouvre les faces d'extrémité du rouleau de réserve par collage de disques de recouvrement.

7. Procédé selon la revendication 6, caractérisé en ce qu'on utilise des disques de recouvrement enduits de thermoadhésif et on les colle sous l'effet d'une pression et de chaleur.

8. Procédé selon la revendication 6, caractérisé en ce que les disques de recouvrement sont flexibles et peuvent être de nouveau retirés avant utilisation du rouleau.

**Claims**

1. Photopolymerizable recording material comprising a flexible, transparent, dimensionally stable temporary support film, a thermoplastic, transferrable photopolymerizable photoresist layer applied to the support film and a flexible covering film on the other surface of the photoresist layer, which adheres less firmly to the photoresist layer than the support film, the material being in form of a roll, wherein the end faces of the roll are covered by glued-on covering disks.

2. A recording material as claimed in claim 1, wherein the covering disks comprise adhesive-coated flexible paper, textile or film sheets.

3. A recording material as claimed in claim 2, wherein the adhesive comprises a hot-melt adhesive.

4. A recording material as claimed in claim 2, wherein the adhesive comprises a pressure-sensitive adhesive.

5. A recording material as claimed in claim 1, wherein the covering disks are rigid.

6. Process for the manufacture of a storable photopolymerizable recording material, which comprises applying a thermoplastic, transferrable photopolymerizable photoresist layer to a flexible, transparent dimensionally stable support film, laminating a flexible covering film to the free surface of the photoresist layer and winding up the composite structure obtained to produce a supply roll, wherein the end faces of the supply roll are covered by gluing on covering disks.

7. A process as claimed in claim 6, wherein covering disks coated with a hot-melt adhesive are used, which are glued on with the application of pressure and heat.

8. A process as claimed in claim 6, wherein the covering disks are flexible and are detached before using the roll.

FIG. 1

FIG. 2